# EUROPÄISCHE PATENTSCHRIFT

(11) **EP 2 986 753 B1**
(45) Veröffentlichungstag und Bekanntmachung des Hinweises auf die Patenterteilung: **20.03.2019**
(21) Anmeldenummer: 14718326.3
(22) Anmeldetag: 14.04.2014
(51) Int. Cl.: C23C 14/32, H01J 37/32

(54) **FUNKENVERDAMPFEN VON METALLISCHEN, INTERMETALLISCHEN UND KERAMISCHEN TARGETMATERIALIEN UM AL-CR-N BESCHICHTUNGEN HERZUSTELLEN**
ARC DEPOSITION OF METAL, INTERMETALLIC, AND CERAMIC TARGET MATERIALS IN ORDER TO PRODUCE AL-CR-N COATINGS
DÉPÔT PAR ÉTINCELAGE DE MATÉRIAUX CIBLES MÉTALLIQUES, INTERMÉTALLIQUES ET CÉRAMIQUES POUR PRODUIRE DES REVÊTEMENTS EN AL CR N

(30) Priorität: 18.04.2013 DE 102013006633
(43) Veröffentlichungstag der Anmeldung: 24.02.2016
(73) Patentinhaber: Oerlikon Surface Solutions AG, Trübbach, 9477 Trübbach (CH)
(72) Erfinder: SABITZER, Corinna, A-9414 Launsdorf (AT); PAULITSCH, Joerg, A-2514 Möllersdorf (AT); POLCIK, Peter, A-6600 Reutte (AT); MAYRHOFER, Paul, Heinz, A-7311 Neckenmarkt (AT); RACHBAUER, Richard, 6800 Feldkirch (AT); ARNDT, Mirijam, 7310 Bad Ragaz (CH)
(74) Vertreter: Misselhorn, Hein-Martin
(86) Internationale Anmeldenummer: PCT/EP2014/000989
(87) Internationale Veröffentlichungsnummer: WO 2014/170003

(56) Entgegenhaltungen:
- CH-A5- 693 035
- DE-A1-102010 042 828
- JP-A- 2001 226 764
- JP-A- 2010 236 060
- BRIAN GABBITAS ET AL: "Microstructural evolution during mechanical milling of Ti/Al powder mixture and production of intermetallic TiAl cathode target", JOURNAL OF MATERIALS SCIENCE, KLUWER ACADEMIC PUBLISHERS, BO, Bd. 47, Nr. 3, 7. September 2011 (2011-09-07), Seiten 1234-1243, XP019993186, ISSN: 1573-4803, DOI: 10.1007/S10853-011-5886-9
- , Retrieved from the Internet: URL:https://de.wikipedia.org/wiki/Intermet allische_Verbindung [retrieved on 2017-10-26]
- , Retrieved from the Internet: URL:https://de.wikipedia.org/wiki/Legierun g [retrieved on 2017-10-26]

## Beschreibung

Die vorliegende Erfindung betrifft ein Beschichtungsverfahren auf der Basis von kathodischem Funkenverdampfen. Ein Kathodisches Funkenverdampfen ist ein bekanntes Verfahren zur Abscheidung von Nitriden wie zum Beispiel AlₓCr₁₋ₓN Schichten bei hohen Beschichtungsraten. Mit diesem Verfahren können dichte und gut auf der Oberfläche haftende Schichten erzielt werden. Allerdings bilden sich bei der Beschichtung Makropartikel (Droplets), welche in die Schichten eingebaut werden und die Schichtqualität verschlechtern. Es kommt besonders dann zur Dropletbildung, wenn ein Target zumindest zwei Metalle enthält, welche sehr unterschiedliche Schmelzpunkte aufweissen, wie das bei Aluminium und Chrom der Fall ist. Dabei kann die Grösse und die Anzahl dieser Droplets durch Erhöhung des Stickstoffflusses reduziert werden.

Demgegenüber ist es Aufgabe der vorliegenden Erfindung, die Zahl und die Grösse der Droplets weiter zu reduzieren.

JP 2010236060 A und JP 2001226764 A offenbaren pulvermetallurgische Verfahren zum Herstellen von Targets.

Erfindungsgemäss wird die Funkenverdampfung mittels pulvermetallurgisch hergestellten Targets betrieben, bei dem die Komponenten als intermetallische Verbindungen vorliegen. D. h. für die Targetherstellung wurde ein Pulver verwendet welches eine intermetallische Verbindung enthält. Beispiel einer solchen intermetallischen Verbindung ist Al₈Cr₅. Hierdurch lässt sich eine Al-Cr-N Schicht erreichen, welche im Wesentlichen eine Komposition metallischer Anteile von 60 at% Al und 40 at% Cr enthält. Soll zum Beispiel eine Schicht mit einem Konzentrationsverhältnis von 70 at% Al und 30 at% Cr hergestellt werden, so kann auf ein Traget mit der intermetallischen Verbindung Al₉Cr₄ zurückgegriffen werden.

Sollen andere Konzentrationsverhältnisse erzielt werden, so kann gemäss einer weiteren Ausführungsform der vorliegenden Erfindung zum Funkenverdampfen ein pulvermetallurgisch hergestelltes Traget verwendet werden, bei dem Pulver einer intermetallischen Verbindung mit dem Pulver einer anderen intermetallischen Verbindung gemischt wurde. Die atomare Konzentration der metallischen Bestandteile richtet sich dann nach dem Mischungsverhältnis der beiden Pulver.

Gemäss einer weiteren Ausführung kann auch auf Targets, welche die keramischen Verbindungen AIN und CrN enthalten, verwendet werden.

Offenbart durch die vorliegende Erfindung wurde:
- Ein Verfahren gemäß dem Anspruch 1
   zum Beschichten eines Substrates mittels kathodischen Funkenverdampfens, wobei als Materialquelle für das Funkenverdampfen ein pulvermetallurgisch hergestelltes Target eingesetzt wird, und wobei das für die Targetherstellung verwendete Pulver eine erste intermetallische Verbindung und eine zweite intermetallische Verbindung enthält.

Ebenfalls offenbart wurde:
- Ein nicht erfindungsgemäßes Verfahren zum Beschichten eines Substrates mittels kathodischen Funkenverdampfens, wobei als Materialquelle für das Funkenverdampfen ein pulvermetallurgisch hergestelltes Target eingesetzt wird, und wobei das für die Targetherstellung verwendete Pulver eine erste keramische Verbindung, vorzugsweise AIN, und eine zweite keramische Verbindung, vorzugsweise CrN, enthält.
- Ein Verfahren wie oben beschrieben, wobei die erste keramische Verbindung AIN . : ist.
- Ein Verfahren wie oben beschrieben, wobei die zweite keramische Verbindung AIN ist.

Gemäss der vorliegenden Erfindung kann auch zur Herstellung mancher Schichten von Vorteil sein, ein Verfahren wie oben beschrieben zu verwenden, aber wobei das für die Herstellung des Targets verwendete Pulver sowohl eine intermetallische Verbindung als auch eine keramische Verbindung enthält.

## Patentansprüche

1. Verfahren zum Beschichten eines Substrates mittels kathodischen Funkenverdampfens eines Targets, welches zumindest zwei Metalle enthält, **dadurch gekennzeichnet, dass** als Materialquelle für das Funkenverdampfen ein pulvermetallurgisch hergestelltes Target eingesetzt wird, wobei das für die Targetherstellung verwendete Pulver eine erste intermetallische Verbindung und eine zweite intermetallische Verbindung enthält.

2. Verfahren nach Anspruch 1, **dadurch gekennzeichnet, dass** das für die Herstellung des Targets verwendete Pulver eine intermetallische Verbindung und eine keramische Verbindung enthält.

3. Verfahren nach Anspruch 1, **dadurch gekennzeichnet, dass** das für die Herstellung des Targets verwendete Pulver die intermetallische Verbindung Al8Cr5 umfasst.

4. Verfahren nach Anspruch 1, **dadurch gekennzeichnet, dass** das für die Herstellung des Targets verwendete Pulver die intermetallische Verbindung Al9Cr4 umfasst.

5. Verfahren nach Anspruch 3 oder 4, **dadurch gekennzeichnet, dass** die Beschichtung in einer Stickstoff-haltigen Atmosphäre durchgeführt wird, um eine Al-Cr-N Schicht zu produzieren.

## Claims

1. A method for coating a substrate by means of cathodic arc vaporization of a target, wherein the target comprises at least two metals,
**characterized in that** a target produced by means of powder metallurgy is used as a material source for the arc vaporization and the powder used for producing the target contains a first intermetallic compound and a second intermetallic compound.

2. The method according to claim 1, **characterized in that** the powder used for producing the target contains an intermetallic compound and a ceramic compound.

3. The method according to claim 1, **characterized in that** the powder used for producing the target contains the intermetallic compound A18Cr5.

4. The method according to claim 1, **characterized in that** the powder used for producing the target contains the intermetallic compound A19Cr4.

5. The method according to claim 3 or 4, **characterized in that** the coating is carried out in a nitrogen-containing atmosphere in order to produce an Al-Cr-N layer.

## Revendications

1. Procédé pour revêtir un substrat au moyen de la vaporisation par étincelage cathodique d'une cible, qui contient au moins deux métaux, **caractérisé en ce que** l'on emploie à titre de source de matériau pour la vaporisation par étincelage une cible produite par métallurgie des poudres, et dans lequel la poudre utilisée pour la production des cibles contient une première combinaison intermétallique et une deuxième combinaison intermétallique.

2. Procédé selon la revendication 1, **caractérisé en ce que** la poudre utilisée pour la production de la cible contient une combinaison intermétallique et une combinaison céramique.

3. Procédé selon la revendication 1, **caractérisé en ce que** la poudre utilisée pour la production de la cible inclut la combinaison intermétallique Al8Cr5.

4. Procédé selon la revendication 1, **caractérisé en ce que** la poudre utilisée pour la production de la cible inclut la combinaison intermétallique Al9Cr4.

5. Procédé selon la revendication 3 ou 4, **caractérisé en ce que** l'opération de revêtement est exécutée dans une atmosphère contenant de l'azote, afin de produire une couche Al-Cr-N.
